# EUROPÄISCHE PATENTSCHRIFT

(11) **EP 3 400 449 B1**
(45) Veröffentlichungstag und Bekanntmachung des Hinweises auf die Patenterteilung: **29.03.2023**
(21) Anmeldenummer: 17703136.6
(22) Anmeldetag: 03.02.2017
(51) Int. Cl.: G01R 22/06, G01R 22/10, G01R 11/54

(54) **MESSEINRICHTUNG ZUR ERMITTLUNG VON ENERGIE-DATEN**
MEASURING DEVICE FOR DETERMINING ENERGY DATA
DISPOSITIF DE MESURE POUR DÉTERMINER LES DONNÉES D'ÉNERGIE

(30) Priorität: 18.02.2016 DE 102016202503
(43) Veröffentlichungstag der Anmeldung: 14.11.2018
(73) Patentinhaber: Siemens Aktiengesellschaft, 80333 München (DE)
(72) Erfinder: JÜRGENS, Dirk, 90475 Nürnberg (DE); HAUSER, Rainer, 90475 Nürnberg (DE)
(74) Vertreter: Siemens Patent Attorneys
(86) Internationale Anmeldenummer: PCT/EP2017/052359
(87) Internationale Veröffentlichungsnummer: WO 2017/140516

(56) Entgegenhaltungen:
- EP-A2- 0 742 443
- EP-A2- 1 764 618
- WO-A1-01/01156
- DE-U1-202009 018 681
- US-A1- 2003 065 459
- US-A1- 2003 154 471
- US-A1- 2014 068 571
- Unknown: "Single phase energy metering IC with pulsed output and digital calibration", , 1. Juni 2011 (2011-06-01), XP055367995, Gefunden im Internet: URL:http://www.st.com/content/ccc/resource /technical/document/datasheet/90/f6/0a/50/ 32/15/40/4f/CD00150901.pdf/files/CD0015090 1.pdf/jcr:content/translations/en.CD001509 01.pdf [gefunden am 2017-04-27]
- Unknown: "Single phase electrical energy counter", , 9. Mai 2008 (2008-05-09), XP055367997, Gefunden im Internet: URL:http://www.electrex.it/en/documentatio n/category/18-etto-d2.html?download=44:dat asheet-etto-d2 [gefunden am 2017-04-27]

## Beschreibung

Die Erfindung betrifft eine Messeinrichtung zur Ermittlung von Energie-Daten gemäß dem Oberbegriff des Anspruchs 1.

Einrichtungen (insbesondere Messeinrichtungen) zur Ermittlung von elektrischer Wirk- und/oder Blindenergie sind aus dem Bereich der Energieverteilung und Energieerzeugung bekannt, zum Beispiel als Leistungsschalter bzw. Umrichter. Bei diesen Einrichtungen ist es häufig wünschenswert, dass die ermittelten digitalen Werte für die Wirk- und/oder Blindenergie (Energie-Daten) nationalem und/oder regionalem Eichrecht entspricht. Mit anderen Worten ist es wünschenswert, verrechnungsfähige Messwerte für die Wirk- und/oder Blindenergie zu ermitteln und bereitzustellen. Die Verrechnungsfähigkeit erfordert eine sogenannte Bauartzulassung, bei der nachzuweisen ist, dass die Einrichtung den Anforderungen der nationalen und/oder regionalen Norm entspricht. Nach der Eichung erfolgt als Schutz vor Manipulationen beispielsweise eine Verplombung oder Versiegelung der Einrichtungen. Die Bauartzulassung gilt dabei für die gesamte Einrichtung, was mit einer deutlichen Erhöhung der Komplexität und als Folge der Kosten für die Entwicklung, Prüfung und Fertigung von solchen Einrichtungen verbunden ist.

Aus der WO 01/01156 A1 ist bereits ein Verfahren zum Messen des Energieverbrauchs mit einem Stromzähler bekannt, das digitale Messgrößen für eine Vielzahl von analogen Phasenspannungen mittels eines A/D-Konverters generiert, um daraus mittels einer Software umsatzbezogene Daten zu erzeugen. Die Software umfasst Programme, von denen eines aktiv und eines inaktiv ist. Die umsatzbezogenen Daten werden jeweils mit dem aktiven Programm erzeugt. Die Programme sind in Programmabschnitten eines EEPROMs gespeichert. Das EEPROM verfügt dazu über entsprechende Speicherplätze, wobei das aktuell vom Stromzähler genutzte Programm jeweils im aktiven Programmabschnitt des EEPROMs gespeichert ist. Soll der Stromzähler während des Betriebs aktualisiert oder neu programmiert werden, wird ein spezielles Verfahren durchgeführt. Um sicherzustellen, dass die Aktualisierung so schnell wie möglich nach Beginn der Änderung erfolgt, wird das aktualisierte/neue Programm in den inaktiven Programmabschnitt im EEPROM geschrieben. Zu Beginn des Schreibens des aktualisierten/neuen Programms in das EEPROM wird das zu diesem Zeitpunkt aktive Programm unterbrochen und die Messdaten werden in einem Zählerspeicher gespeichert. Nach erfolgreichem Abschluss des Programm-Updates oder dem Laden des neuen Programms wird der inaktive Programmabschnitt, welcher das neue Programm enthält, zum aktiven Programmabschnitt erklärt und der Messvorgang mit diesem fortgeführt, wobei die während des Updates im Zählerspeicher gespeicherten Messdaten von dem dann neu aktiven Programm verarbeitet werden.

Insbesondere ist dabei nachteilig, dass im Falle eines erforderlichen Firmware-Updates die Bauart jeweils neu zugelassen werden muss.

Weiter offenbart die US 2003/154471 A1 ein Verfahren zum Aktualisieren der Firmware einer elektronischen Vorrichtung. Das Verfahren wird über eine Kommunikationsverbindung ausgeführt und beinhaltet die Komprimierung eines Teils der neuen Firmware, erfordert aber nicht, dass das Gerät bereits vorhandene Dekompressionsalgorithmen integriert hat.

Aus der EP 1 764 618 A2 ist ferner ein Zähler zum Messen von Leistungsparametern an einer oder mehreren elektrischen Stromleitungen/Lasten bekannt, der so konfiguriert ist, dass er mit oder ohne abnehmbares Messmodul arbeitet. Der Zähler weist eine Messschaltung auf, die eine umsatzstarke Messung und Analyse der Netzqualität für eine Stromleitung bzw. -last ermöglicht. Das Messmodul kann an einer von außen zugänglichen Stelle des Zählers montiert werden, um dessen Funktionalität zu ändern, ohne die äußeren Abmessungen des Zählers zu vergrößern und ohne die am Zähler angebrachten manipulationssicheren Siegel zu beschädigen.

Die Aufgabe der Erfindung ist es, eine Messeinrichtung anzugeben, bei der ein Firmware-Update möglich ist, ohne die Bauartzulassung der Messeinrichtung zu verletzen.

Die Aufgabe wird durch die Merkmale des Anspruchs 1 gelöst; die Unteransprüche stellen vorteilhafte Ausgestaltungen dar.

Die Lösung sieht vor, dass die Firmware eine erste und zweite Firmware aufweist, wobei die erste Firmware auf einem ersten Prozessor arbeitet und updatefähig ist und die zweite Firmware auf einem eigenen zweiten Prozessor arbeitet und nichtupdatefähig ist, wobei die nicht-updatefähige Firmware unabhängig von der updatefähigen Firmware arbeitet und zumindest Zugriff auf die digitalen Messwerte hat. Die Unabhängigkeit der nicht-updatefähigen Firmware ist insbesondere dadurch besser sichergestellt, dass die updatefähige Firmware und die nicht-updatefähige Firmware jeweils auf einem eigenen Prozessor laufen.

Die Gebrauchsfähigkeit der Messeinrichtung lässt sich verbessern, wenn durch die Anzeige die verrechnungsfähigen Energie-Daten anzeigbar sind.

Um die Verrechnungsfähigkeit mit einem einzigen Display sicherzustellen, wird vorgeschlagen, dass die Anzeige vom Anzeigen von Daten der updatefähigen Firmware auf das Anzeige der verrechnungsfähigen Energie-Daten umschaltbar ist.

Eine einfache Umschaltung sieht vor, dass diese mittels eines Schalters mit mechanischen Kontakten erfolgt.

Besonders übersichtlich ist es, wenn die Anzeige als Display ausgebildet ist.

Eine besonders einfache Anzeige lässt sich realisieren, wenn die Anzeige eine LED ist.

Besonders einfach und anschaulich lassen sich die Energie-Daten (die Energie) anzeigen, wenn die LED proportional zum Energiewert blinkt.

Die Variabilität ist erfindungsgemäß verbessert, da die nicht-updatefähige Firmware auf einem bauartzugelassenen geeichten und versiegelten Modul läuft.

Die Unabhängigkeit lässt sich vergrößern, wenn das Modul eine eigene Anzeige aufweist.

Die Erfindung wird nachfolgend anhand eines Ausführungsbeispiels einer Messeinrichtung zur Ermittlung der elektrischen Energie beschrieben, welche in Form eines elektrischen (Energie-)Stroms durch eine elektrische Leitung fließt. Dazu verfügt die Messeinrichtung über Messeingänge, die als Strom- und Spannungseingänge ausgebildet sind und an denen Signale in Form von elektrischen Strom- und Spannungssignalen anliegen. Die Messeingänge gehören zu einem Frontend der Messeinrichtung, an dessen Ausgängen die Strom- und Spannungssignale als Messwerte zur Verfügung stehen.

Die Messeinrichtung verfügt weiter über einen ersten Prozessor, auf dem zur Durchführung seiner Hauptfunktionen eine updatefähige Firmware (Software) läuft, die dazu auf die digitalisierten Messwerte zugreift. Die Anzeige von Daten, welche die (Haupt-)Funktionen betreffen, erfolgt auf einem Display der Messeinrichtung.

Weiter ist auf die Messeinrichtung ein bauartzugelassenes geeichtes und versiegeltes Modul aufgesteckt (aufsteckbar), in dem ein zweiter Prozessor (oder ein Mess-ASIC und dergleichen) ausschließlich für den verrechnungsfähigen Teil zuständig ist und dieser Teil abgeschlossen ist und unabhängig vom ersten Prozessor arbeitet. Auf dem zweiten Prozessor läuft also eine nicht-updatefähige Firmware (unabhängig) von der auf dem ersten Prozessor laufenden updatefähigen Firmware.

Nur das geeichte und versiegelte Modul ist für sich bauartzugelassen und verrechnungsfähig.

Die im Modul laufende nicht-updatefähige Firmware greift ebenfalls auf die digitalisierten Messwerte zu und berechnet aus diesen verrechnungsfähige Energie-Daten für die elektrische Wirk- und/oder Blindenergie.

Die verrechnungsfähigen Energie-Daten werden auf einer direkt am Modul befindlichen (also integrierten) Anzeige angezeigt, die als Display ausgebildet ist.

In einer ersten Alternative ist es auch möglich, dass die Anzeige von Daten der updatefähigen Firmware auf die Anzeige von verrechnungsfähigen Energie-Daten mittels eines mechanischen Schalters umschaltbar ist.

Alternativ kann die Anzeige weiter auch lediglich eine am Modul angeordnete LED sein, welche proportional zum verrechnungsfähigen Energiewert blinkt.

Die zweite nicht-updatefähige Firmware kann gerätemäßig insbesondere als Energie-Zähler oder als Messkopf ausgebildet sein.

## Patentansprüche

1. Messeinrichtung zur Ermittlung von Energie-Daten anhand von elektrischen Signalen, die an Messeingängen anliegen, mit einem Frontend, das Ausgänge aufweist, an denen die digitalen Werte der elektrischen Signale als digitale Messwerte zur Verfügung stehen,
mit einer ersten und zweiten Firmware, die auf die digitalisierten Messwerte zugreift und aus diesen abgeleitete Daten berechnet, wobei die abgeleiteten Daten Energie-Daten umfassen, und
mit einer Anzeige der Energie-Daten,
wobei die erste Firmware auf einem ersten Prozessor arbeitet und updatefähig ist und die zweiten Firmware auf einem eigenen zweiten Prozessor arbeitet und zumindest Zugriff auf die digitalen Messwerte hat, **dadurch gekennzeichnet,**
**dass** die zweite Firmware nicht-updatefähig ist, und dass die nicht-updatefähige Firmware unabhängig von der updatefähigen Firmware arbeitet und auf einem bauartzugelassenen geeichten und versiegelten Modul läuft.

2. Messeinrichtung nach Anspruch 1,
**dadurch gekennzeichnet,**
**dass** durch die Anzeige die Energie-Daten anzeigbar sind.

3. Messeinrichtung nach Anspruch 1 oder 2,
**dadurch gekennzeichnet,**
**dass** die Anzeige vom Anzeigen von Daten der updatefähigen Firmware auf das Anzeigen der Energie-Daten umschaltbar ist.

4. Messeinrichtung nach Anspruch 3,
**dadurch gekennzeichnet,**
**dass** die Umschaltung der Anzeige mittels eines Schalters mit mechanischen Kontakten erfolgt.

5. Messeinrichtung nach einem der Ansprüche 1 - 4,
**dadurch gekennzeichnet,**
**dass** die Anzeige als Display ausgebildet ist.

6. Messeinrichtung nach einem der Ansprüche 1 - 4,
**dadurch gekennzeichnet,**
**dass** die Anzeige eine LED ist.

7. Messeinrichtung nach Anspruch 6,
**dadurch gekennzeichnet,**
**dass** die LED proportional zum Energiewert blinkt.

8. Messeinrichtung nach einem der Ansprüche 1-7,
**dadurch gekennzeichnet,**
**dass** das Modul eine eigene Anzeige aufweist.

## Claims

1. Measuring device for determining energy data on the basis of electrical signals present at measurement inputs, comprising a frontend having outputs at which the digital values of the electrical signals are available as digital measurement values,
comprising first and second firmware which accesses the digitized measurement values and calculates data derived from them, the derived data comprising energy data, and comprising an indicator for the energy data,
the first firmware operating on a first processor and being updatable
and the second firmware operating on a dedicated second processor and at least has access to the digital measurement values, **characterized**
**in that** the second firmware is non-updatable, and
**in that** the non-updatable firmware operates independently of the updatable firmware and runs on a design-approved calibrated and sealed module.

2. Measuring device according to Claim 1,
**characterized**
**in that** the energy data are indicatable by the indicator.

3. Measuring device according to Claim 1 or 2,
**characterized**
**in that** the indicator is switchable from indicating data of the updatable firmware to indicating the energy data.

4. Measuring device according to Claim 3,
**characterized**
**in that** the switching of the indicator is effected by means of a switch with mechanical contacts.

5. Measuring device according to any of Claims 1-4,
**characterized**
**in that** the indicator is embodied as a display.

6. Measuring device according to any of Claims 1-4,
**characterized**
**in that** the indicator is an LED.

7. Measuring device according to Claim 6,
**characterized**
**in that** the LED flashes proportionally to the energy value.

8. Measuring device according to any of Claims 1-7,
**characterized**
**in that** the module has a dedicated indicator.

## Revendications

1. Dispositif de mesure destiné à la détermination de données énergétiques à l'aide de signaux électriques qui sont adjacents à des entrées de mesure, avec une extrémité avant qui présente des sorties au niveau desquelles les données numériques des signaux électriques sont disponibles en tant que valeurs de mesure numériques, avec un premier et un second micrologiciel, lequel second micrologiciel accède aux données de mesure numérisées et calcule des données dérivées de celles-ci, dans lequel les données dérivées comprennent des données énergétiques, et avec un affichage des données énergétiques, dans lequel le premier micrologiciel travaille sur un premier processeur et peut être mis à jour et le second micrologiciel travaille sur un second processeur qui lui est propre et a au moins accès aux données de mesure numériques, **caractérisé en ce que** le second micrologiciel ne peut pas être mis à jour et **en ce que** le micrologiciel qui ne peut pas être mis à jour travaille indépendamment du micrologiciel qui peut être mis à jour et fonctionne sur un module calibré homologué et verrouillé.

2. Dispositif de mesure selon la revendication 1, **caractérisé en ce que** les données énergétiques peuvent être affichées par le biais de l'affichage.

3. Dispositif de mesure selon la revendication 1 ou 2, **caractérisé en ce que** l'affichage peut être commuté de l'affichage de données du micrologiciel qui peut être mis à jour sur l'affichage des données énergétiques.

4. Dispositif de mesure selon la revendication 3, **caractérisé en ce que** la commutation de l'affichage se produit au moyen d'un commutateur avec des contacts mécaniques.

5. Dispositif de mesure selon l'une quelconque des revendications 1 à 4, **caractérisé en ce que** l'affichage est réalisé en tant qu'écran.

6. Dispositif de mesure selon l'une quelconque des revendications 1 à 4, **caractérisé en ce que** l'affichage est une DEL.

7. Dispositif de mesure selon la revendication 6, **caractérisé en ce que** la DEL clignote proportionnellement à la valeur énergétique.

8. Dispositif de mesure selon l'une quelconque des revendications 1 à 7, **caractérisé en ce que** le module présente un affichage qui lui est propre.
